Europäisches Patentamt

European Patent Office

Office européen des brevets

(11) Veröffentlichungsnummer: **0 254 127**
**A2**

## (12) EUROPÄISCHE PATENTANMELDUNG

(21) Anmeldenummer: 87109816.6

(22) Anmeldetag: 07.07.87

(51) Int. Cl.⁴: **H01J 37/244**

(30) Priorität: 25.07.86 DE 3625199

(43) Veröffentlichungstag der Anmeldung:
27.01.88 Patentblatt 88/04

(84) Benannte Vertragsstaaten:
**DE FR GB NL**

(71) Anmelder: **Siemens Aktiengesellschaft Berlin
und München**
**Wittelsbacherplatz 2**
**D-8000 München 2(DE)**

(72) Erfinder: **Frosien, Jürgen, Dr.-Ing.**
**An der Ottosäule 18**
**D-8012 Ottobrunn(DE)**
Erfinder: **Schmitt, Reinhold, Dipl.-Ing.**
**Josef-Kiefer-Weg 6**
**D-8000 München 83(DE)**

(54) Detektor für geladene Teilchen.

(57) Der erfindungsgemäße Detektor besteht im wesentlichen aus einer auf Erdpotential liegenden zylindrischen Schirmelektrode (ZE), einem innerhalb der Schirmelektrode (ZE) konzentrisch zu deren Symmetrieachse (ZA) angeordneten Szintillator (SZ), der mit Hilfe einer Halterung (H) auf dem Lichtleiter (LL) befestigt ist. Zur Verbesserung der fokussierenden Eigenschaften des Detektors ist der metallisierte und auf hohen positiven Potential liegende Szintillator (SZ) konusförmig oder in Form eines Rotationsparaboloids ausgebildet.

FIG 2

## Detektor für geladene Teilchen

Die Erfindung bezieht sich auf Detektoren für geladene Teilchen nach den Oberbegriffen der Patentansprüche 1 und 2.

Trifft ein primärer Korpuskularstrahl auf einen Fest-körper, so werden aufgrund der Wechselwirkung der Primärteilchen mit der Festkörpersubstanz Sekundärkorpuskeln emittiert, deren Energie-und Winkelverteilung von der im Wechselwirkungsbereich vorliegenden chemischphysikalischen Zusammensetzung, der Oberflächenstruktur und der auf der Probe vorhandenen Potentialverteilung abhängt. Von besonderer Bedeutung für die Bilderzeugung in Rasterelektronenmikroskopen sind die in oberflächennahen Bereichen ausgelösten Sekundärelektronen, die man üblicherweise mit einem oberhalb der Probe angeordneten Detektorsystem nachweist. Ein in konventionellen Rasterelektronenmikroskopen häufig verwendeter Sekundärelektronendetektor ist aus der Veröffentlichung von T. E. Everhardt, R. F. M. Thornley "Wide-band detector for micro-microampere low-energy electron currents", Journ. Scien. Instr. Vol 37 (Juli 1960), Seite 246-248 bekannt.

Für quantitative Spannungsmessungen an Knotenpunkten mikroelektronischer Bauelemente ist das Rasterelektronenmikroskop zusätzlich mit einem zwischen Probe und Objektivlinse angeordneten Gegenfeldspektrometer zur Bestimmung der vom Meßpunktpotential abhängigen Verschiebung der Energieverteilung der Sekundärelektronen ausgestattet. Diese Gegenfeldspektrometer bestehen zumeist aus einer Absaugelektrode, einer Gegenfeldelektrode und einer Ablenkeinheit zur Beschleunigung der Sekundärelektronen in Richtung des seitlich oberhalb der Probe angeordneten Detektors. Die in Rasterelektronenmikroskopen üblicherweise vorhandenen Detektoren sind aufgrund ihrer großen Bauhöhe für Spannungsmessungen allerdings kaum geeignet, da sie auch Sekundärelektronen erfassen, die das Gegenfeld des Spektrometers nicht durchlaufen haben. Es wurden deshalb Rohrlinsendetektoren entwickelt, die man unmittelbar hinter dem Austrittsfenster der Ablenkeinheit anordnet (siehe beispielsweise H. P. Feuerbaum "VLSI testing using the electron probe" SEM/1979/I, Seite 285-296 insbesondere Fig. 13). In diesen verbesserten Detektoren kann man bedingt durch die geringe Bauhöhe des Spektrometers allerdings nur Szintillatoren mit kleiner Oberfläche verwenden, so daß nicht alle der energieanalysierten und in Richtung des Detektors abgelenkten Sekundärelektronen nachgewiesen werden.

Der Erfindung liegt die Aufgabe zugrunde Detektoren der eingangs genannten Art anzugeben, die auch bei niedrigen Teilchenströmen trotz geringer Bauhöhe eine deutlich höhere Nachweiswahrscheinlichkeit als konventionelle Detektoren aufweisen. Bei quantitativen Potentialmessungen soll insbesondere sichergestellt sein, daß das mit den Dektoren gemessene Signal nicht durch Änderungen der Winkelverteilung der von der Probe emittierten Sekundärelektronen beeinflußt wird.

Diese Aufgabe wird erfindungsgemäß durch Detektoren nach Patentanspruch 1 oder 2 gelöst.

Der mit den erfindungsgemäßen Detektoren erzielbare Vorteil besteht insbesondere darin, daß das Signal-RauschVerhältnis und damit die Auflösung bei quantitativen Potentialmessungen deutlich gesteigert werden kann.

Die Ansprüche 3 und 4 sind auf bevorzugte Ausgestaltungen und Weiterbildungen der erfindungsgemäßen Detektoren nach Anspruch 1 oder 2 gerichtet.

Die erfindungsgemäßen Detektoren werden nachfolgend anhand der Zeichnungen erläutert.

Dabei zeigen:

Fig. 1 einen konventionellen Rohrlinsendetektor,

Fig. 2 und 3 Ausführungsbeispiele erfindungsgemäßer Detektoren für Sekundärelektronen und andere geladene Teilchen.

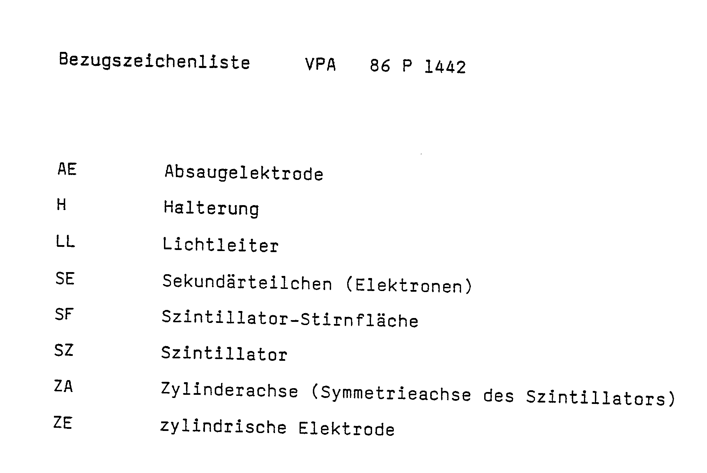

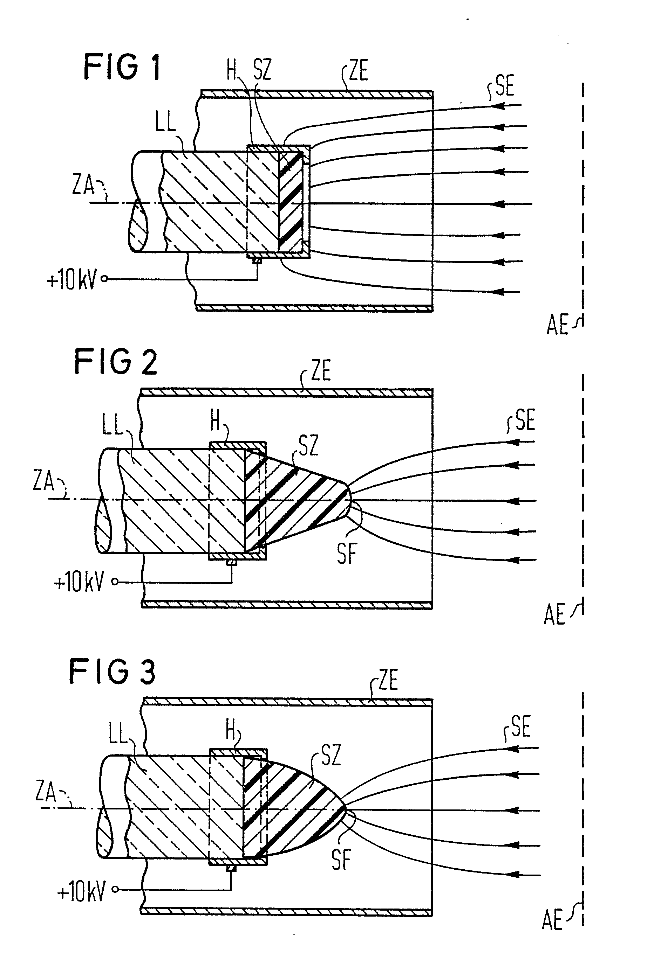

Der bekannte, in Fig. 1 schematisch dargestellte Rohrlinsendetektor besteht aus einer auf Erdpotential liegenden zylindrischen Schirmelektrode ZE und einem innerhalb der Schirmelektrode ZE konzentrisch zu deren Symmetrieachse ZA angeordneten ebenen Szintillator SZ, der mit Hilfe der mit Anschlußklemmen versehenen Halterung H auf dem Lichtleiter LL befestigt ist. Um eine ausreichend hohe Photonenausbeute im Szintillator SZ zu erzeugen, müssen die die Umlenkelektrode AE des Gegenfeldspektrometers durchlaufenden niederenergetischen Sekundärelektronen SE ($E_{kin}<$ 50 eV) auf hohe kinetische Energien beschleunigt werden. Dies wird erreicht, in dem man die metallisierte, im allgemeinen kreisförmige Szintillatorstirnfläche über die Halterung H auf ein Potential von beispielsweise + 10 kV legt. Die im fokussierenden Feld der Anordnung beschleunigten Sekundärelektronen SE wechselwirken mit dem Szintiallatormaterial und regen dessen Atome/Moleküle zur Emission kurzer Lichtimpulse an, die über den Lichtleiter LL der Photokathode eines in Fig. 1 nicht dargestellten Photomultipliers zugeführt und in ein elektrisches Signal umgewandelt werden. Mit Rohrlinsendetektoren der gezeigten Art gelingt es allerdings nicht, alle Sekundärelektronen SE auf die Stirnfläche des Szintillators zu fokussieren. Aufgrund der relativ großen Energiebreite der Sekundärelektronen SE wird das Sekundärelektronenbündel im Detektor so aufgeweitet, daß das entstehende Farbfehlerscheibchen, wie in Fig. 1 schematisch dargestellt, deutlich größer als die wirksame Szintillatorstirnfläche ist.

Ausführungsbeispiele erfindungsgemäßer Detektoren für Sekundärelektronen und andere geladene Teilchen sind in den Fig. 2 und 3 dargestellt, in denen gleiche Bezugszeichen gleiche Anordnungselemente wie in Fig. 1 bezeichnen. Die Detektoren bestehen aus einer auf Erdpotential liegenden zylindrischen Schirmelektrode ZE und einem innerhalb der Schirmelektrode ZI konzentrisch zu deren Symmetrieachse ZA angeordneten Szintillator SZ, der mit Hilfe der Halterung H auf dem Lichtleiter LL befestigt ist. Im Unterschied zu dem bekannten Rohrlinsendetektor, bei dem die Halterung H einen Teil der ebenen Szintillatorstirnfläche abdeckt, sind hier die metallisierten und auf hohen positiven Potential liegenden Szintillatoren SZ konusförmig (Fig. 2) bzw. in Form eines Rotationsparaboloids (Fig. 3) ausgebildet, so daß die durch Halterungen H verursachten Abschattungseffekte nicht mehr auftreten. Außerdem wird die effektive Szintillatoroberfläche und damit das Signal-Rausch-Verhältnis bei gleichbleibender Bauhöhe des Detektors deutlich gesteigert. Weitere Vorteile der erfindungsgemäßen Detektoren werden im folgenden am Beispiel der in modifizierten Rasterelektronenmikroskopen durchgeführten Messungen des zeitlichen Potentialverlaufes an Knotenpunkten hochintegrierter Schaltungen erläutert.

Werden in einer integrierten Schaltung Testprogramme abgearbeitet, so treten an deren Knotenpunkten und Leiterbahnen charakteristische, den jeweiligen Betriebszustand definierende Signale auf, deren Zeitabhängigkeit man mit einer Elektronensonde abtasten und zur Fehleranalyse mit den aus Simulationsrechnungen gewonnenen Signalverläufen vergleichen kann. Der zeitliche Verlauf hochfrequenter Signale kann in Elektronenstrahl-Meßgeräten zur Zeit nur mit Hilfe des beispielsweise aus der Veröffentlichung von H. P. Feuerbaum bekannten Sampling-Verfahrens gemessen werden, bei dem man den auf dem interessierenden Meßpunkt positionierten Primärelektronenstrahl synchron mit dem dort auftretenden Signal eintastet und die vom Potential des Meßpunktes abhängige Verschiebung der Energieverteilung der ausgelösten Sekundärelektronen in einem Gegenfeldspektrometer bestimmt. Der zeitliche Potentialverlauf wird dann durch Verschieben des Eintastzeitpunktes der Primärelektronenpulse kontinuierlich mit einer von der Pulsbreite abhängigen Zeitauflösung aufgezeichnet. Um hochfrequente Signalverläufe mit sehr guter Zeitauflösung zu messen, muß man mit extrem kurzen Primärelektronenpulsen arbeiten. Bei den mit modernen Strahlaustastsystemen erreichbaren Pulsbreiten von 100 ps führt dies bei Strahlenströmen im Nanoamperebereich zu Primärelektronenimpulsen die nur noch einzelne Elektronen enthalten und die entsprechend wenige Sekundärelektronen am Meßpunkt auslösen. Ein ausreichend hoher Signalpegel ist am Eingang der dem Detektor nachgeschalteten Meßelektronik deshalb nur dann zu erwarten, wenn möglichst alle der das Spektrometer durchlaufenden Sekundärelektronen vom Detektor erfaßt werden. Diese Forderung wird von den in Fig. 2 und 3 dargestellten Detektoren in nahezu idealer Weise erfüllt. Durch die konische bzw. parabolische Ausbildung des Szintillators SZ wird die fokussierende Wirkung des Detektors deutlich verbessert, da die Sekundärelektronen SE wegen der erhöhten elektrischen Feldstärke am Szintillator SZ vorwiegend auf dessen Stirnfläche SF auftreffen. Diese Eigenschaft der erfindungsgemäßen Detektoren ist bei quantitativen Potentialmessungen von besonderer Bedeutung, da die durch Spannungsänderung auf einer der dem Meßpunkt benachbarten Leiterbahnen verursachten Änderungen der Winkelverteilung der von der Probe emittierten Sekundärelektronen zu Verschiebungen der Sekundärelektronenverteilung auf der Detektoroberfläche führen. In konventionellen Anordnungen werden deshalb bei gleichem Meßpunktpotential unterschiedliche Sekundärelektronenströme gemessen. Die damit einhergehenden Meßfehler treten bei den erfindungsgemäßen Detektoren nicht mehr auf, da die Verschiebung der Sekundärelektronenverteilung gering bleibt und auch die außerhalb der Stirnfläche auftretenden Sekundärelektronen noch nachgewiesen werden. Durch die spezielle Oberflächenform der Szintillatoren SZ ist außerdem sichergestellt, daß man nahezu die gesamte im Szintillatorvolumen erzeugte Strahlungsintensität durch Totalreflexion an den Oberflächen dem Lichtleiter LL und damit der Photokathode des Photomultipliers zuführt. Die damit gegenüber Anordnungen mit ebnen oder halbkugelförmigen Szintillatoren erreichte Vergrößerung der Apertur des Detektorsystems führt unmittelbar zu einem deutlich besseren Signal-Rausch-Verhältnis. Zusammenfassend bleibt deshalb festzustellen, daß die Nachweisempfindlichkeit für Sekundärelektronen, die die kürzeste noch zu einem auswertbaren Signal führende Pulsdauer und damit die maximal mögliche Zeitauflösung bestimmt mit den erfindungsgemäßen Detektoren erheblich gesteigert wird.

**Ansprüche**

1. Detektor für geladene Teilchen mit einem Szintillator (SZ), einem Lichtleiter (LL), einer Halterung (H) zur Befestigung des Szintillators (SZ) auf dem Lichtleiter (LL) und einer Elektrodenanordnung (ZE) zur Fokussierung der Teilchen (SE) **gekennzeichnet** durch einen konusförmig ausgebildeten Szintillator (SZ).

2. Detektor für geladene Teilchen mit einem Szintillator (SZ) einem Lichtleiter (LL), einer Halterung (H) zur Befestigung des Szintillators (SZ) auf dem Lichtleiter (LL) und einer Elektrodenanordnung (ZE) zur Fokussierung der Teilchen (SE) **gekennzeichnet** durch einen in Form eines Rotationsparaboloids ausgebildeten Szintillator (SZ).

3. Detektor nach Anspruch 1 oder 2, **gekennzeichnet** durch eine konzentrisch zur Symmetrieachse (ZA) des Szintillators (SZ) angeordnete zylindrische Elektrode (ZE).

4. Detektor nach einem der Ansprüche 1 bis 3, dadurch **gekennzeichnet**, daß die zylindrische Elektrode (ZE) auf Erdpotential liegt.

Bezugszeichenliste     VPA    86 P 1442


AE          Absaugelektrode

H           Halterung

LL          Lichtleiter

SE          Sekundärteilchen (Elektronen)

SF          Szintillator-Stirnfläche

SZ          Szintillator

ZA          Zylinderachse (Symmetrieachse des Szintillators)

ZE          zylindrische Elektrode


Bn I Myr - 09.09.86

0 254 127

FIG 1

FIG 2

FIG 3